# EUROPEAN PATENT SPECIFICATION

(11) **EP 2 917 945 B1**
(45) Date of publication and mention of the grant of the patent: **09.01.2019**
(21) Application number: 13798429.0
(22) Date of filing: 06.11.2013
(51) Int. Cl.: H01L 41/27, H01L 41/293, H01L 41/45, H01L 41/083, H01L 41/047

(54) **STACKED ELECTROACTIVE TRANSDUCER AND FABRICATION METHOD THEREOF**
GESTAPELTER ELEKTROAKTIVER WANDLER UND HERSTELLUNGSVERFAHREN DAFÜR
TRANSDUCTEUR ÉLECTROACTIF EMPILÉ ET SON PROCÉDÉ DE FABRICATION

(30) Priority: 06.11.2012 US 201261722954 P; 10.04.2013 US 201361810328 P; 15.05.2013 US 201361823534 P
(43) Date of publication of application: 16.09.2015
(73) Proprietor: Parker-Hannifin Corporation, Cleveland, OH 44124 (US)
(72) Inventor: SUTHERLAND, William, D., Los Gatos, CA 95032 (US); WU, Patrick, Sunnyvale, CA 94086 (US); LIPAWAT, Pat, Santa Clara, CA 95054 (US); MOUSAVI NAZARI, Hooman, Daly City, CA 94014 (US); BIGGS, Silmon, James, Los Gatos, CA 95033 (US)
(74) Representative: Murgitroyd & Company
(86) International application number: PCT/US2013/068650
(87) International publication number: WO 2014/074554

(56) References cited:
- WO-A1-2005/086249
- WO-A1-2009/112988
- WO-A2-2012/118916
- DE-A1- 10 335 019
- US-A- 4 500 377
- US-A1- 2005 157 893
- US-A1- 2010 109 486
- US-A1- 2011 021 917

## Description

### FIELD OF THE INVENTION

The present invention is directed in general to manufacturing processes and test methods for stacked actuators. More particularly, the present invention is directed to actuators having stacked layers of electroactive polymers. The present invention is also directed to actuators having stacked layers of electroactive polymers interspersed with layers of passive elastomers.

### BACKGROUND OF THE INVENTION

A tremendous variety of devices used today rely on actuators of one sort or another to convert electrical energy to mechanical energy. Conversely, many power generation applications operate by converting mechanical action into electrical energy. Employed to harvest mechanical energy in this fashion, the same type of device may be referred to as a generator. Likewise, when the structure is employed to convert physical stimulus such as vibration or pressure into an electrical signal for measurement purposes, it may be characterized as a sensor. Yet, the term "transducer" may be used to generically refer to any of the devices.

A number of design considerations favor the selection and use of advanced dielectric elastomer materials, also referred to as "electroactive polymers," for the fabrication of transducers. These considerations include force, power density, power conversion/consumption, size, weight, cost, response time, duty cycle, service requirements, environmental impact, etc. As such, in many applications, electroactive polymer technology offers an ideal replacement for piezoelectric, shape-memory alloy and electromagnetic devices such as motors and solenoids.

An electroactive polymer transducer comprises two electrodes having deformable characteristics and separated by a thin elastomeric dielectric material. When a voltage difference is applied to the electrodes, the oppositely charged electrodes attract each other thereby compressing the polymer dielectric layer therebetween. As the electrodes are pulled closer together, the dielectric polymer film becomes thinner (the Z-axis component contracts) as it expands in the planar directions (along the X- and Y-axes), i.e., the displacement of the film is in-plane. The electroactive polymer film may also be configured to produce movement in a direction orthogonal to the film structure (along the Z-axis), i.e., the displacement of the film is out-of-plane. For example, U.S. Pat. No. 7,567,681 discloses electroactive polymer film constructs which provide such out-of-plane displacement also referred to as surface deformation or as thickness mode deflection.

The material and physical properties of the electroactive polymer film may be varied and controlled to customize the deformation undergone by the transducer. More specifically, factors such as the relative elasticity between the polymer film and the electrode material, the relative thickness between the polymer film and electrode material and/or the varying thickness of the polymer film and/or electrode material, the physical pattern of the polymer film and/or electrode material (to provide localized active and inactive areas), the tension or pre-strain placed on the electroactive polymer film as a whole, and the amount of voltage applied to or capacitance induced upon the film may be controlled and varied to customize the features of the film when in an active mode.

Numerous applications exist that benefit from the advantages provided by such electroactive polymer films whether using the film alone or using it in an electroactive polymer actuator. One of the many applications involves the use of electroactive polymer transducers as actuators to produce haptic, tactile, vibrational feedback (the communication of information to a user through forces applied to the user's body), and the like, in user interface devices. There are many known user interface devices which employ such feedback, typically in response to a force initiated by the user. Examples of user interface devices that may employ such feedback include keyboards, keypads, game controller, remote control, touch screens, computer mice, trackballs, stylus sticks, joysticks, etc. The user interface surface can comprise any surface that a user manipulates, engages, and/or observes regarding feedback or information from the device. Examples of such interface surfaces include, but are not limited to, a key (e.g., keys on a keyboard), a game pad or buttons, a display screen, etc.

The feedback provided by these types of interface devices is in the form of physical sensations, such as vibrations, pulses, spring forces, etc., which a user senses either directly (e.g., via touching of the screen), indirectly (e.g., via a vibrational effect such a when a cell phone vibrates in a purse or bag) or otherwise sensed (e.g., via an action of a moving body that creates a pressure disturbance sensed by the user). The proliferation of consumer electronic media devices such as smart phones, personal media players, portable computing devices, portable gaming systems, electronic readers, etc., can create a situation where a sub-segment of customers would benefit or desire an improved haptic effect in the electronic media device. However, increasing feedback capabilities in every model of an electronic media device may not be justified due to increased cost or increased profile of the device. Moreover, customers of certain electronic media devices may desire to only temporarily improve the haptic capabilities of the electronic media device for certain activities.

Use of electroactive polymer materials in consumer electronic media devices as well as the numerous other commercial and consumer applications highlights the need to increase production volume while maintaining precision and consistency of the films.

Conventional fabrication techniques for producing stacked electroactive polymer actuators include batch processes where multiple dielectric layers are laminated or cast in place. However, these techniques are inefficient and difficult to scale to large volume manufacturing. Fabrication by continuous lamination of two polymer films with electrodes thereon onto a roll with final cutting is known from WO2005/086249 A1 or US 4,500,377. The present disclosure provides semi-continuous manufacturing techniques for producing stacked actuators that are efficient and scalable to high volume manufacturing as compared to conventional batch processes.

Modern manufacturing methods require the flexibility to support multiple design alternatives and materials to support a broad product line. Any such process must be scalable, stable and repeatable and consider both front end and back end assembly processes. For example, it is desirable to assess the quality of individual devices through a test such as voltage withstand yield at the front end of the current stacking process. In addition, final assembly of a stacked actuator into an actuator assembly requires a reliable method of making an electrical connection. Conventional techniques are time consuming and not very scalable. There is also a need for a process of more efficiently creating vias components that is scalable for volume production as part of the back end assembly process.

For high volume manufacturing, care must be taken to minimize process variation and the introduction of defects. Some conventional methods for producing stacked actuators require the application of an adhesive, usually by spraying. Such techniques increase the dielectric thickness of the actuator, which increases operating voltage. Variation in adhesive thickness contributes to variation in yield and overall performance. Dielectric film lamination for stacked actuators on a batch basis is very time consuming and contributes significant opportunities for the occurrence of defects in the form of bubbles and wrinkles. Conventional stacked actuator process may include casting and laminating one or more thick polymer slabs onto the electroactive polymer stack. The process, however, is slow, manual, and prone to defects as it is difficult to manipulate the soft and fragile slabs.

Conventional batch processes are not easily scalable into a high volume manufacturing process. The present disclosure provides efficient and scalable techniques for producing stackable actuators. Some techniques, such as printing dielectric material, may help reduce the thickness of the dielectric layers, lower operating voltages, and eliminate the need for adhesive spraying and dielectric film lamination, and are efficient and scalable for volume manufacturing. These new methods also facilitate the cost-effective manufacturing of new device architectures with enhanced performance.

### SUMMARY OF THE INVENTION

The present invention provides a method of fabricating a multilayer stacked electroactive transducer according to claim 1, and a multilayer stacked electroactive transducer made thereby according to claim 11. Advantageous features are set out in the dependent claims. In one embodiment, a roll-to-sheet method for fabricating a multilayer stack for the production of one or more stacked actuators is provided. The inventive method comprises advancing a first electroactive polymer film to a fixed position; applying a first electrode material to the electroactive polymer film; optionally applying a first adhesive material, to the electroactive polymer film; optionally cutting the electroactive polymer film to a sheet of predetermined length; advancing and laminating a second electroactive polymer film over the first electrode and adhesive materials of the first electroactive polymer film; curing the laminated multilayer stack; applying a second electrode material, to the laminated multilayer stack; optionally applying a second adhesive material to the laminated multilayer stack; optionally repeating the steps of applying the electroactive polymer film and the electrode materials; cutting the laminated multilayer stack to a sheet of a predetermined length; stacking the cut laminated sheets; and laminating the cut laminated sheets.

In another embodiment, the electroactive polymer film may be formed from a dielectric resin cast in-line before applying it to the multilayer stack. In yet another embodiment, the adhesive may be applied onto the electroactive polymer film before it is applied to the multilayer stack. In another embodiment, one or more passive polymer layers may be applied to the surfaces of the multilayer stack or interspersed between the active electroactive polymer layers.

In one embodiment, a loop method for fabricating a stacked actuator is provided. The method comprises providing an electroactive polymer multilayer stack in a semi-continuous cyclic process and during each cycle: applying a first dielectric material to the film; applying a first electrode material in at least a first pattern; applying a second dielectric material to the film; and applying a second electrode material, in at least a second pattern.

In one embodiment, a loop cast method for fabricating a stacked actuator is provided, The method comprises providing an electroactive polymer multilayer stack in a semi-continuous cyclic process and during each cycle: applying a first dielectric resin to the film; at least partially curing the first dielectric resin; applying a first electrode material in at least a first pattern; applying a second dielectric resin to the film; at least partially curing the second dielectric resin; and applying a second electrode material in at least a second pattern.

In one embodiment, a continuous loop laminating method for fabricating a stacked actuator is provided. The method comprises providing a carrier liner in a continuous cyclic process and during each cycle: laminating a first electroactive polymer film onto the carrier liner; applying at least one electrode material to the first laminated film layer; optionally applying at least one adhesive material to the first laminated film layer; and curing the first laminated film layer.

Any of the methods above may further comprise repeating the steps of applying a dielectric material, to the multilayer stack and applying the electrode materials to build up the number of layers desired. The electrodes with the first electrode pattern are aligned through all the layers; similarly the electrodes with the second electrode pattern are aligned through all the layers.

In one embodiment, the cyclic process may include multiple applications of dielectric resin before applying the electrode pattern to build up the thickness of the dielectric layer. In yet another embodiment, an adhesive may be applied onto the electroactive polymer film before it is applied to the multilayer stack. In other embodiments, one or more passive polymer layers may be applied to the surfaces of the multilayer stack or interspersed between the active electroactive polymer layers.

The application of the dielectric layers, electrode layers, adhesive layers, and passive polymers layers may be distributed at different locations around the loop. In one embodiment, the loop is supported by a web driven by at least two rollers. In another embodiment, the loop is supported by a rigid drum.

In one embodiment, a stacked actuator is provided. The stacked actuator comprises a plurality of active electroactive polymer layers arranged in a stack; a first passive polymer layer attached to a first surface of the stacked plurality of active electroactive polymer layers; and a second passive polymer layer attached to a second surface of the stacked plurality of active electroactive polymer layers, wherein the second surface is opposite the first end.

In another embodiment, a stacked actuator with enhanced stroke performance is provided. The stacked actuator comprises a plurality of active electroactive polymer layers arranged in a stack and a plurality of passive polymer layers interspersed between the active electroactive polymer layers.

In one embodiment, a method of producing an actuator assembly is provided, the method comprises providing electrical connections to all of the layers in the multilayer stacked transducer by piercing at least a first via through all of the first electrode patterns; piercing at least a second via through all of the second electrode patterns; and filling the vias with a conductive material. In some embodiments, it is advantageous to position the vias near the center of the footprint of the device.

In one embodiment, a method of producing an actuator assembly is provided, the method comprises providing at least two stacked actuators; piercing at least one via through each of the at least two stacked actuators; and filling the at least one via with a conductive material.

These and other features and advantages of the invention will become apparent to those persons skilled in the art upon reading the details of the invention as more fully described below. In addition, variations of the processes and devices described herein include combinations of the embodiments or of aspects of the embodiments where possible are within the scope of this disclosure even if those combinations are not explicitly shown or discussed.

### BRIEF DESCRIPTION OF THE DRAWINGS

The invention is best understood from the following detailed description when read in conjunction with the accompanying drawings. To facilitate understanding, the same reference numerals have been used (where practical) to designate similar elements are common to the drawings. Included in the drawings are the following:
FIG. 1A illustrates a roll-to-sheet lamination process suitable for the present invention;
FIG. 1B is a detail view of the vacuum belt according to FIG. 1A;
FIG. 2 shows a loop cast single coater process suitable for the present invention;
FIG. 3 depicts a loop cast multiple coater process suitable for the present invention;
FIG. 4 illustrates a loop cast drum process suitable for the present invention;
FIG. 5 shows a loop cast film roll and drum process suitable for the present invention;
FIG. 6 depicts a continuous lamination process suitable for the present invention;
FIG. 7 illustrates a stacked actuator according to one embodiment of the present invention;
FIG. 8 is a cross-sectional view of a stacked actuator according to one embodiment of the present invention;
FIG. 9 illustrates a stroke transmission multiplier stacked actuator according to one embodiment of the present invention;
FIG. 10 shows the stroke length of a basic stacked actuator according to one embodiment of the present invention;
FIG. 11 depicts an enhanced ground interface stacked actuator according to one embodiment of the present invention;
FIG. 12 illustrates a stroke transmission multiplier stacked actuator according to one embodiment of the present invention;
FIG. 13 provides a flow diagram of a stacked actuator manufacturing process suitable for the present invention;
FIG. 14 depicts the standard method of positioning electrical contacts on the outside of a stacked actuator;
FIG. 15 shows one embodiment of the internal contact stacked actuator of the present invention; and
FIG 16 shows another embodiment of the internal contact stacked actuator of the present invention.

Variation of the invention from that shown in the figures is contemplated.

### DETAILED DESCRIPTION OF THE INVENTION

Examples of electroactive polymer devices and their applications are described, for example, in U.S. Pat. Nos. 7,394,282; 7,378,783; 7,368,862; 7,362,032; 7,320,457; 7,259,503; 7,233,097; 7,224,106; 7,211,937; 7,199,501; 7,166,953; 7,064,472; 7,062,055; 7,052,594; 7,049,732; 7,034,432; 6,940,221; 6,911,764; 6,891,317; 6,882,086; 6,876,135; 6,812,624; 6,809,462; 6,806,621; 6,781,284; 6,768,246; 6,707,236; 6,664,718; 6,628,040; 6,586,859; 6,583,533; 6,545,384; 6,543,110; 6,376,971; 6,343,129; 7,952,261; 7,911,761; 7,492,076; 7,761,981; 7,521,847; 7,608,989; 7,626,319; 7,915,789; 7,750,532; 7,436,099; 7,199,501; 7,521,840; 7,595,580; 7,567,681; 7,595,580; 7,608,989; 7,626,319; 7,750,532; 7,761,981; 7,911,761; 7,915,789; 7,952,261; 8,183,739; 8,222,799; 8,248,750, and in U.S. Patent Application Publication Nos. 2007/0200457; 2007/0230222; 2011/0128239; and 2012/0126959.

### STACKED ACTUATOR MANUFACTURING PROCESSES

Described hereinbelow are various embodiments of manufacturing processes for manufacturing stacked actuators. In various embodiments, a stacked actuator may be manufactured using sheet stacking processes, a roll-to-sheet lamination process including a vacuum belt process, various loop cast processes, and a semi-continuous lamination process. These processes are described hereinbelow.

### Sheet Stacking Process #1

In one embodiment, a sheet stacking manufacturing process includes printing a dielectric material on a polymer film and laminating (stacking) multiple layers of printed polymer films. Although practical devices can be made with up to four layers of laminated polymer film, there is no limitation to the number of layers than can be stacked. The multiple layers can be stacked manually or automatically with automatic assembly machines from McClellan Automation Systems of NH, for example. Current batch frames and printing processes can be utilized in this technique and may be ideally suited for development purposes. In one embodiment, the polymer film may be pre-strained prior to the free standing dielectric screen printing process.

### Sheet Stacking Process # 2

In another embodiment, another sheet stacking manufacturing process includes laminating a polymer film coming off of a stretcher to a platen or flat plate. Electrodes and adhesive can be screen printed on one side. It is acceptable to have the bottom layer inactive and electrically isolated. Another layer of polymer film can be laminated to the stack on the platen / plate prior to the next printing step. No pre-strain of the polymer film would be required for accurate printing. Layer-to-layer alignment may be simplified by printing dielectric material on clear polymer films. Accurate layer-to-layer printing on opaque film is also contemplated but may require mechanical alignment techniques and the polymer film will need to be mounted to a stable base. This technique may be better suited for large scale manufacturing than Process #1.

### Roll-To-Sheet Lamination Process

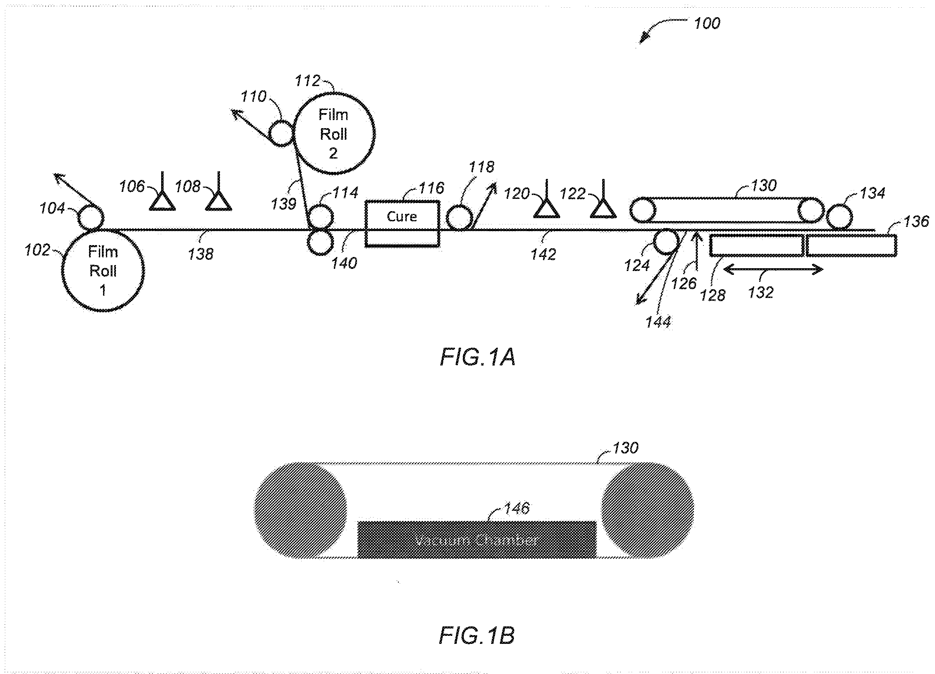

FIG. 1A illustrates a roll-to-sheet lamination process **100** according to one embodiment. The roll-to-sheet lamination process **100** may be employed to fabricate stacked actuators according to various embodiments. In the illustrated process **100**, two rolls **102**, **112** of electroactive polymer film **138**, **139** feed the process **100** line. The interleaf liner for each film **138**, **139** is removed by respective rolls **104**, **110** during the unwind process. A first electrode deposition station 106 and a first adhesive deposition station **108** apply electrode and adhesive materials onto the first film **138**. A second film **139** is laminated onto the first film **138** after the electrode and adhesive deposition steps by lamination rolls **114**. The laminated film **140** is then cured at a curing station **116**. The coat liner is removed from the second film **139** by a roll **118**. A second electrode deposition station **120** and a second adhesive deposition station **122** apply dielectric and adhesive materials on the exposed side of the second film **142**. A vacuum belt **130**, or similar apparatus, holds the elastic film **142** as the coat liner is removed from the first film **138** portion of the laminated film **142** by a roll **124** and the film **144** is then laminated onto the stack. The film **144** is cut **126** into sheets which are laminated by lamination roll **134** to create stacks **136**. The sheet lamination table **128** may move side-to-side in direction **132** or rise and fall to receive a new layer. The process **100** is repeated until the desired number of stacked layers is achieved.

In one embodiment, the web may be about 1m in width and move in a continuous manner at about 1m/min. Other widths and speeds, however, are contemplated and are within the scope of the present disclosure. The process can also be carried out in a step-and-repeat manner. Deposition methods for electrode and adhesive at stations **106** / **120**, **108** / **122** may be selected from a wide range of solutions including aerosol jet, ultrasonic spray, screen printing, rotary screen, flexographic, gravure, etc.

FIG. 1B illustrates a detail view of the vacuum belt **130** according to one embodiment. Additional mechanisms may be required to hold, precision align, and laminate sheets for the vacuum belt **130** to hold the film **142** (FIG. 1A) during peeling of the coat liner. In one embodiment, the vacuum belt **130** is porous or has perforations over most of its width. The edges of the belt **130** are configured to seal with sides of a vacuum box **146**. The surface area of the belt **130** over the vacuum chamber **146** pulls the film **142** into firm contact with the belt **130**. The film **142** is released when it reaches the limit of the vacuum chamber. The vacuum belt **130** concept may be useful in any design where unsupported dielectric film is moving through a web system. It may prove particularly useful in a roll-to-sheet concept because something must hold the film while peeling the last liner. Multiple vacuum belts **130** can be used in series for long runs.

### Loop Cast Single Coater Process

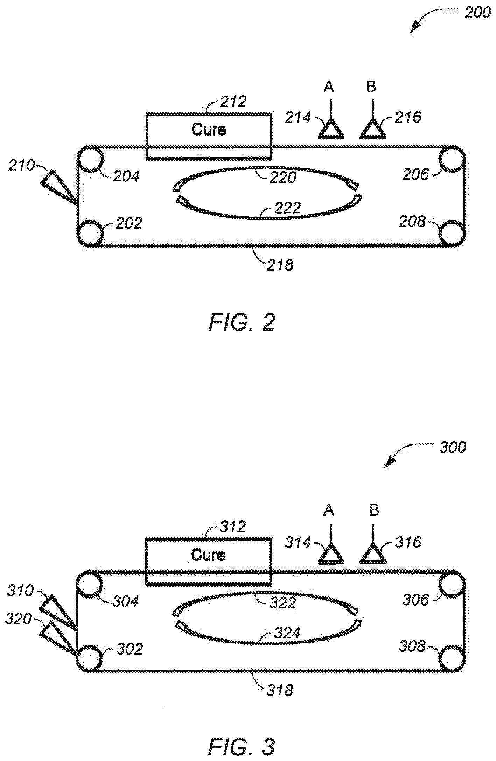

FIG. 2 illustrates a loop cast single coater process **200** according to one embodiment. The loop cast single coater process **200** may be employed to fabricate stacked actuators according to various embodiments. A belt or web of electroactive polymer film **218** is supported by a plurality of rolls **202**, **204**, **206**, **208**. It should be kept in mind that although four rolls are shown, the illustrated embodiment is not limited thereto. As the rolls **202**, **204**, **206**, **208** rotate, the film **218** web rotates in the direction indicated by arrows **220**, **222**. A single coater **210** applies a layer of dielectric material onto the polymer film **218**. The coater **210** may be any suitable coater including, without limitation, a slot die, extrusion coater, knife coater, curtain coater, and the like. A single curing station **212** cures the dielectric material applied to the film **218**. Electrode patterns A and B can be printed onto the film **218** by electrode deposition stations **214**, **216**. Different patterns A, B may be achieved either by alternating between the two electrode deposition stations **214**, **216** or shifting alignment of a single electrode deposition station. A similar concept may be applied to other embodiments illustrated herein as well with the coater **210** replaced by a lamination module. A new layer may be added with each rotation of the film **218** web. Alternatively, the web may rotate multiple times between electrode depositions to build up the thickness of the dielectric layers.

### Loop Cast Multiple Coaters Process

FIG. 3 illustrates a loop cast multiple coater process **300** according to one embodiment. The loop cast multiple coater process **300** may be employed to fabricate stacked actuators according to various embodiments. A belt or web of electroactive polymer film **318** is supported by a plurality of rolls **302**, **304**, **306**, **308**. Again, although four rolls are shown, the illustrated embodiment is not limited thereto. As the rolls **302**, **304**, **306**, **308** rotate, the film **318** web rotates in the direction indicated by arrows **322**, **324**. A first coater **310** applies a dielectric layer of material onto the polymer film **318** and a second coater **320** applies a passive layer of polymer material onto the polymer film **318**. The second coater **320** can apply passive slab or stroke multiplication layers during some or all of the rotations of the web loop. Such layers may be thicker or made of a different material than the dielectric material layers applied by the first coater **310**. These special layers also may be laminated onto the film **318**. The coaters **310**, **320** may be any suitable coaters including, without limitation, slot dies, extrusion coaters, knife coaters, curtain coaters, and the like. Multiple layer coatings such as those from a two-layer slot die may also be applied simultaneously to eliminate the need for separate coaters. In some device architectures, one of the layers could be a conductive material to eliminate the need for one of the electrode deposition stations. A single curing station **312** cures the passive and dielectric materials as well as the electrode patterns applied to the film **318**. Electrode patterns A and B can be printed onto the film **318** by electrode deposition stations **314**, **316**. Different patterns A, B can be achieved either by alternating between the two electrode deposition stations **314**, **316** or shifting alignment of a single electrode deposition station. A similar concept may be applied to other embodiments illustrated herein as well with the coaters **310**, **320** replaced by a lamination module. A new layer is added with each rotation of the film **318** web. Alternatively, the web may rotate multiple times between electrode depositions to build up the thickness of the dielectric or passive layers

### Loop Cast Drum Process

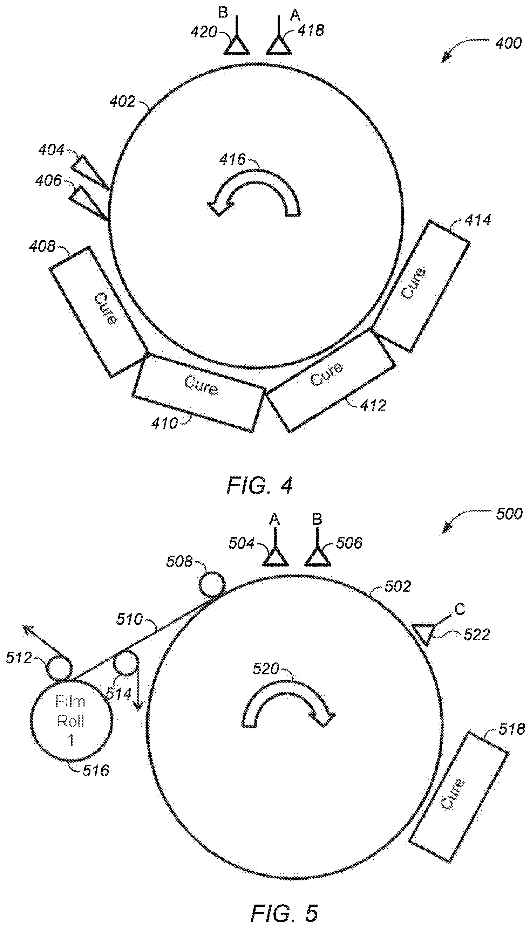

FIG. 4 illustrates a loop cast drum process **400** according to one embodiment. The loop cast drum process **400** may be employed to fabricate stacked actuators according to various embodiments. A drum **402** rotates in the direction indicated by arrow **416** and provides a stable surface for coating and printing. Dual coaters **404**, **406** are provided to apply a passive layer of material and a dielectric layer of material, onto the surface of an electroactive polymer film provided about the drum **402**. Electrode patterns A and B can be printed onto the film by electrode deposition stations **418**, **420**. Different patterns A, B can be achieved either by alternating between the two electrode deposition stations **418**, **420** or shifting alignment of a single electrode deposition station. Multiple curing stations **408**, **410**, **412**, **414** are provided about the drum **402** to cure the passive and dielectric layers as well as the electrode patterns applied to the film. As previously discussed, the coaters **404**, **406** may be any suitable coaters including, without limitation, slot dies, extrusion coaters, knife coaters, curtain coaters and the like. The drum may be covered with a removable liner for ease of set-up and clean-up or for removing and supporting the multilayer stack material at the end of the fabrication process.

### Loop Cast Film Roll And Drum Process

FIG. 5 illustrates a loop cast film roll and drum process **500** according to one embodiment. The loop cast film roll and drum process **500** may be employed to fabricate stacked actuators according to various embodiments. As shown, the loop / drum process **500** is employed in a lamination scheme. An electroactive polymer film **510** is unwound from a film roll **516**. The interleaf liner is peeled by a first roll **512** and the coat liner is peeled by a second roll **514**. The film **510** is then laminated onto a film located about a drum **502**, which rotates in the direction indicated by arrow **520** by a lamination roll **508**. Alternatively, the interleaf liner can be peeled by lamination roll **508** to support the electroactive polymer film **510** before lamination. Electrode patterns A and B can be printed onto the film by electrode deposition stations **504**, **506**. Different patterns A, B can be achieved either by alternating between the two electrode deposition stations **504**, **506** or shifting alignment of a single electrode deposition station. An adhesive deposition station **522** applies a layer of adhesive onto the film **510**. A curing station **518** cures the electrode and adhesive layers applied to the film **510**.

### Continuous Lamination Process

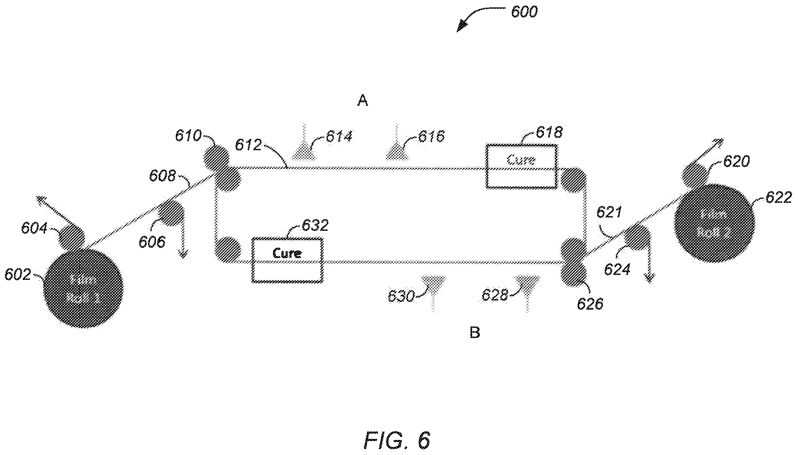

FIG. 6 illustrates a continuous lamination process **600** according to one embodiment. The continuous lamination process **600** may be employed to fabricate stacked actuators according to various embodiments. A carrier liner **612** is threaded like a belt through the tool. Liners are removed from a precast film roll **602**. The interleaf liner is removed by a first roll **604** and a peel coat liner is removed by a second roll **606**. Alternatively, the interleaf liner can be removed by lamination roll **610**. The film **608** is laminated to the carrier liner **612** by lamination roll **610**. Electrode and adhesive pattern A is deposited using any method by deposition stations **614**, **616**. Post deposition curing at curing station **618** prepares the adhesive for lamination. The liners are removed from a second film roll **622**. The interleaf liner is removed by a third roll **620** and a peel coat liner is removed by a fourth roll **624**. Alternatively, the peel coat liner is removed by lamination roll **626**. The film **621** is laminated to the belt **612** by lamination roll **626**. Electrode and adhesive pattern B is deposited on the second laminated film **621**. The belt **612** circulates until a desired number of layers are laminated. The belt **612** is cut and sent to a segmenting tool. The web preferably is about 1m in width and moves at about a 1m/min continuous rate, although other widths and speeds are contemplated as being within the scope of the present disclosure. Deposition methods for the electrode and adhesive layers may be a range of solutions including aerosol jet, ultrasonic spray, flexographic printing, rotary screen, among others. The carrier liner needs good adhesion but will release at end of the process **600**. Process modules to apply additional materials and layers can be added by varying the length of the belt **612**.

### STACKED ACTUATOR MANUFACTURING PROCESSES AND TEST METHODS

### Stroke Multiplier Stacked Actuator

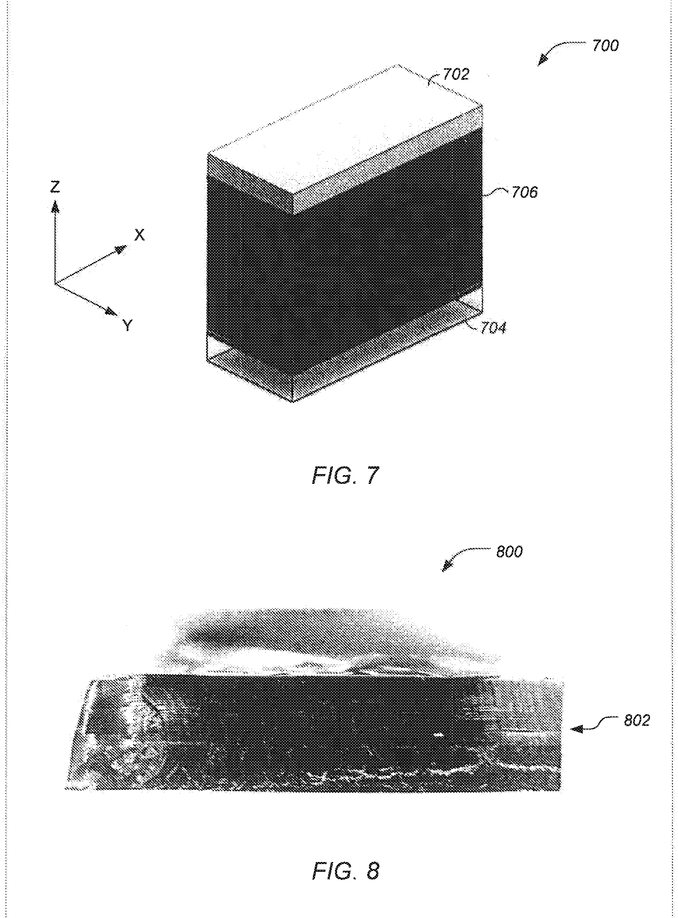

FIG. 7 illustrates a stacked actuator **700** according to one embodiment. The Stacked actuator **700** comprises top and bottom passive layers **702**, **704** with layers of electroactive polymer films **706** stacked to a desired thickness. In the illustrated embodiment, the stacked actuator **700** is comprised of stacks active layers of film **706** and pattered electrode up to a desired height. It has been demonstrated, however, that the use of an enhanced ground interface design improves the stroke of a stacked actuator. A passive layer at the ground and load interfaces enables all active electroactive polymer layers to fully deform under an electrical input. In one embodiment, the stacked actuator **700** may comprise 20 dielectric layers of dielectric with alternate A/B pattern electrodes and fabricated on a 0.030" (0.762 mm) silicone slab. Un-patterned adhesive is used between layers, which may be fabricated in various lengths and widths.

FIG. 8 is a cross-sectional view of one-half of a stacked actuator **800** according to one embodiment. The depicted stacked actuator comprises 26 layers of electroactive active polymer on top of a passive layer of elastomer (a slab).

It is relatively easy to add force to a stacked actuator **700**, **800** by increasing the actuator area. Stroke, however, generally requires adding layers with a relatively small incremental improvement in stroke with each added layer or the use of a separate mechanical transmission device to convert force into stroke. Either approach adds cost and complexity to the system solution. An enhanced ground interface provides an improvement over basic stacked actuator design because it replaces active electroactive polymer layers with a passive layer at the points connected to solid surfaces. This is effective in small layer count devices with relatively thin passive layers, but it reaches limits of effectiveness as the layer count is increased.

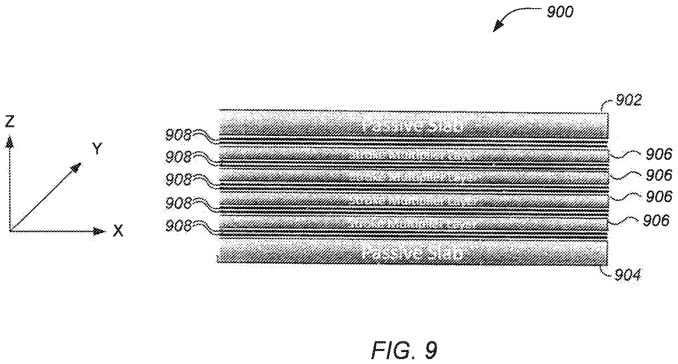

FIG. 9 illustrates a stroke transmission multiplier stacked actuator **900** according to one embodiment. The stroke transmission multiplier stacked actuator **900** comprises one or more active electroactive polymer layers **908** interspersed by passive elastomer polymer layers **906**, which act as stroke multiplier layers, and then capped on the ends with passive elastomer polymer layers **902**, **904**, which act as enhanced ground interfaces. This combination may repeated until the desired active layer count is achieved. Such a configuration may be particularly useful in applications where stroke is a primary concern and excess force is available. Some lateral (x-y) force from the active electroactive polymer layers **908** is applied to the deformation of the stroke multiplier layer adding to the overall (z) stroke achieved by the stroke transmission multiplier stacked actuator **900**. The passive elastomer polymer layers **906** (stroke multiplier layers) may preferably be 1-10 X the total thickness of the active electroactive polymer layers **908**, but there is no fundamental constraint and latitude for design optimization is envisioned. Also, the passive layers **902**, **904** on the ends may have a thickness that is greater than the thickness of each of thicknesses of the active electroactive polymer layers **906** and the passive elastomer polymer layers **902**, **904**. The modulus of a passive elastomer polymer layer **906** may preferably be equal to or lower than the modulus of the active electroactive polymer layers **908**, but there is no fundamental requirement and latitude for design optimization is envisioned. The ends are capped with passive layers **902**, **904** that act as a ground interface to enhance the performance of the stroke transmission multiplier stacked actuator **900**.

Interspersing the passive elastomer layers **906** into a stack of active electroactive polymer layers **908** increases the displacement / stroke of the stroke transmission multiplier stacked actuator **900**. The passive elastomer polymer layers **906** are interspersed between and bonded to the active electroactive polymer layers **908**. An actuated active electroactive polymer film layer **908** expands in area (x-y) while thinning (z). A passive polymer layer **906** is deformed in the same manner by the motion of the active electroactive polymer layers **908** above and below. The result is greater stroke for a stacked actuator for the same number of active electroactive polymer layers **908**. Thus, for the same number, area, shape, and thickness of active electroactive polymer layers **908** (e.g., capacitance) the stroke transmission multiplier stacked actuator **900** is able to produce more stroke under the same electric energy input. The use of inactive or passive polymer layers **906** to amplify the stroke, and may reduce the overall cost of a stacked actuator compared to an equivalent corresponding increase in active electroactive layer count where increased stoke is desired.

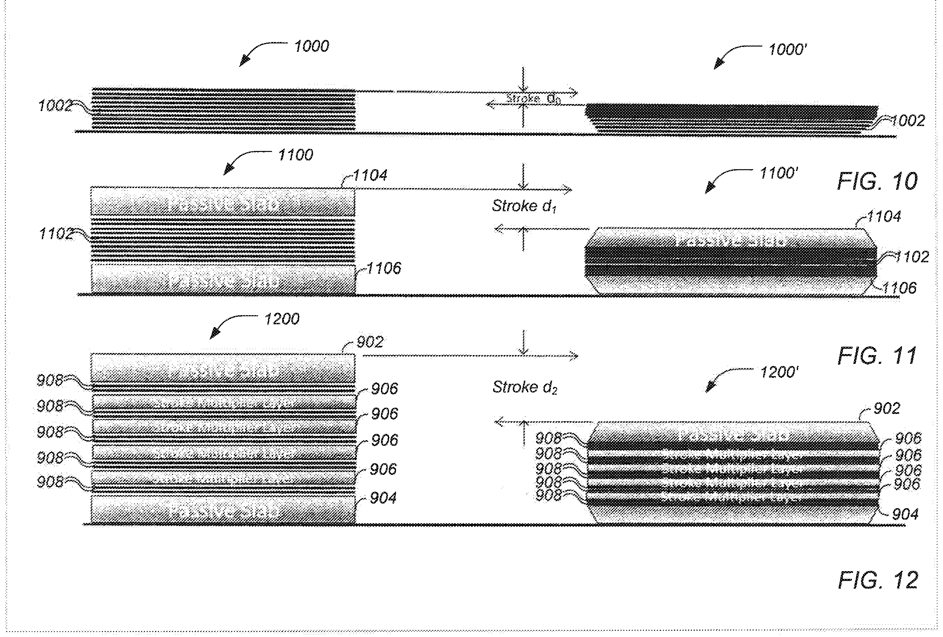

FIGS. 10-12 illustrate a comparison in stroke length between a basic stacked actuator **1000** shown in FIG. 10, an enhanced ground interface stacked actuator **1100** shown in FIG. 11, and a stroke transmission multiplier stacked actuator **1200** shown in FIG. 12, according to various embodiments. As shown, the basic stacked actuator **1000** shown in FIG. 10 provides the shortest stroke distance whereas the stroke transmission multiplier stacked actuator **1200** shown in FIG. 12 provides the greatest stroke distance with the stroke distance of the enhanced ground interface stacked actuator **1100** shown in FIG. 11 falling therebetween.

FIG. 10 illustrates the stroke length of a basic stacked actuator **1000** according to one embodiment. On the left side of the diagram, the basic stacked actuator **1000** is shown in an inactive form with the electroactive polymer layers in a de-energized state. On the right side of the diagram, the basic stacked actuator **1000'** is shown in an activated form with the electroactive polymer layers **1002** in an energized state. As shown, the difference in height between the de-energized basic stacked actuator **1000** and the energized basic stacked actuator **1000'** is defined as the stroke d₀.

FIG. 11 illustrates an enhanced ground interface stacked actuator **1100** according to one embodiment. The enhanced ground stacked actuator **1100** comprises a plurality of electroactive polymer layers **1102** sandwiched between passive elastomer polymer layers **1104**, **1106**, which act as an enhanced ground interface. On the left side of the diagram, the enhanced ground stacked actuator **1100** is shown in an inactive form with the electroactive polymer layers in a de-energized state. On the right side of the diagram, the enhanced ground stacked actuator **1100'** is shown in an activated form with the electroactive polymer layers **1102** in an energized state. As shown, the difference in height between the de-energized enhanced ground interface stacked actuator **1100** and the energized enhanced ground interface stacked actuator **1100'** is defined as the stroke d₁, which is greater than the stroke d₀ obtained with the basic stacked actuator **1000** shown in FIG. 10.

FIG. 12 illustrates a stroke transmission multiplier stacked actuator **1200** according to one embodiment. The stroke transmission multiplier stacked actuator **1200** comprises a plurality of active electroactive polymer layers **908** interspersed between passive elastomer polymer layers **908**, which act as stroke multiplier layers, and capped on the ends by passive elastomer polymer layers **902**, **904**, which act as an enhanced ground interface. As shown in FIG. 12, in one embodiment, the thickness of the passive elastomer polymer layers **906** is greater than the thickness of the active electroactive polymer layers **908** and the end cap passive layers **902**, **904** are thicker than the passive elastomer polymer layers **906**. On the left side of the diagram, the stroke transmission multiplier stacked actuator **1200** is shown in an inactive form with the electroactive polymer layers in a de-energized state. On the right side of the diagram, the stroke transmission multiplier stacked actuator **1200'** is shown in an activated form with the electroactive polymer layers **908** in an energized state. As shown, the difference in height between the de-energized stroke transmission multiplier stacked actuator **1200** and the energized stroke transmission multiplier stacked actuator **1200'** is defined as the stroke d₂, which is greater than the stroke d₁ obtained with the enhanced ground interface stacked actuator **1100** shown in FIG. 11 or the stroke d₀ obtained with the basic stacked actuator **1000** shown in FIG. 10.

### Stacked Actuator Manufacturing Process

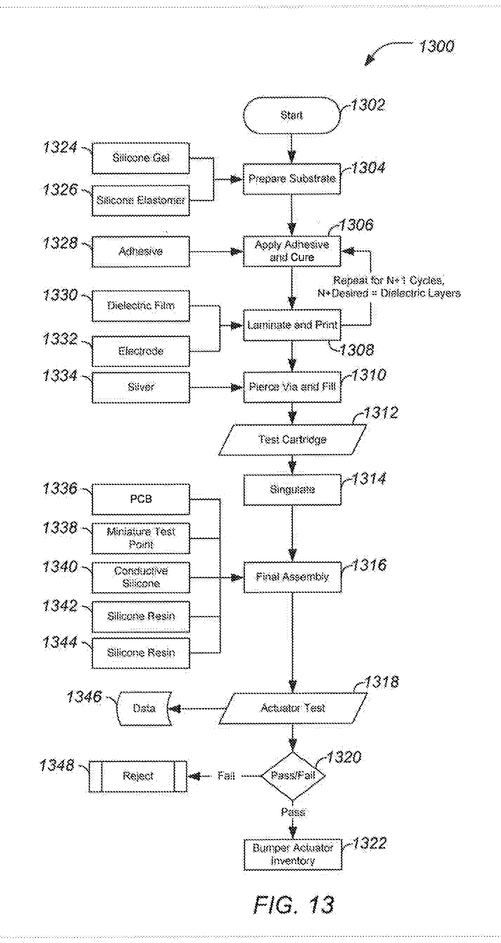

FIG. 13 illustrates a flow diagram of a stacked actuator manufacturing process **1300** according to one embodiment. Generally, the process **1300** flow for fabricating stacked actuators improves quality by reducing bubbles, wrinkles, and other defects that are common when stacking multiple layers of polymeric materials. Back-end preparation of a stacked actuator for test or use in a final application includes two general steps: (1) piercing or slicing vias into the actuators; and (2) filling the vias with a conductive material to electrically connect all of the layers in the stacked actuator. In one embodiment, the process **1300** employs a jig that slices the vias in the correct location for filling the conductive material, but avoiding the active area. In one embodiment, a dual-blade knife jig is employed to slice the vias. The process **1300** also includes a test method for performing voltage withstand, resistance, and capacitance tests. The stacking process cycle may be simplified to comprise the following steps: printing and curing electrodes and printing and curing dielectric material. Multiple deposition methods have been considered including screen printing, stencil printing, spraying, doctor blade casting, slot die casting, and gravure printing, all of which are contemplated to be within the scope of the present disclosure. Stencil printing the silicone slab may potentially be an order of magnitude faster than the current casting processes. Other methods like continuous casting with a slot die or knife blade are also considered to be within the scope of the present disclosure.

Furthermore, the process **1300** provides a method for creating robust electrical and mechanical connections from the stack actuator to a metallic conductor (e.g., a conductive pad on a printed circuit board [PCB]), by one or more of the following techniques: (1) dipping the ends of stacked actuator in a conductive elastomer and curing it; (2) inserting the actuator and a printed circuit board into the cavity of a die and injection molding conductive elastomer to form terminals that join them; and (3) providing a base with conductive anchoring elements that protrude in the vias and are captured by the conductive elastomer when it is cured, to provide a mechanical armature that resists pull-out of the terminal and adds conductive area to the metal/elastomer interface in order to reduce contact resistance.

Conductive silicone adheres to both the end of a stack actuator and to a printed circuit board or wire. Thus, a single material and process both fastens and electrically connects the actuator to copper-based conductors which can be soldered or terminated with conventional connectors. Molding the silicone around a mechanical/electrical anchor soldered to a copper wire or copper pad on a printed circuit board increases pull-out strength and lowers electrical resistance. Overmolding a compliant insulating layer of silicone provides further mechanical robustness and prevents unintended electrical connections.

The process **1300** increases productivity of fabricating stacked actuators over conventional techniques and can be scaled to high volume production. The process step of creating via connections allows tor the possibility of in-process quality control, which may be desired for efficient process development. It also addresses some scaling issues and process enables automation.

Printing the dielectric enables thinner layers of dielectric which will help achieve desired operating voltage levels. It also replaces two difficult and time consuming process steps (adhesive deposition and film lamination) with one. The adhesive deposition involves a high degree of process variation and adds to dielectric thickness, resulting in poorer product consistency and higher operating voltages. The second process replaced is film lamination, which can be time consuming and laborious, and prone to defects such as bubbles, wrinkles, and dielectric film damage. Printing dielectric is not only much faster than the processes it replaces, it also doesn't have any of the negative consequences described above. Stencil printing is a much faster and more efficient way to produce thick passive layers in comparison to conventional methods.

The process **1300** may be employed to fabricate a actuator assembly by combining two stacked actuators having, for example, 20 dielectric layers each, as shown and described in connection with FIG. 7, for a total of, for example, 40 dielectric layers when the two components are combined into one actuator assembly. Conductive silicone and printed circuit board with anchoring elements are utilized for electrical connection and the assembly is encapsulated in silicone.

Turning now to the process **1300**, which starts at **1302**, the substrate is prepared **1304** by applying a mixture of silicone gel **1324** and silicone elastomer **1326** onto a shim interposed between release liners. The substrate is heat pressed to flatten and cure, the shims and liners are removed and the substrate is cut to size. The substrate in inserted into an aluminum platen. A frame is employed such that multiple substrates can be processed simultaneously and then singulated into individual components later in the process **1300** (e.g., at step **1314**). The substrate can alternatively be prepared by any other suitable technique including, without limitation, stencil printing and slot die coating. Singulation can be done with any suitable technique including, without limitation, knife or blade cutting, die cutting, laser cutting, ultrasonic cutting, and water jet cutting. Components can be separated one at a time or simultaneously in multiples with, for example, an array or roller of cutting dies.

Adhesive **1328** is applied to the substrate and cured **1306**. The adhesive **1328** may preferably be a silicone with tensile modulus <1 MPa diluted with solvent to a viscosity suitable for spraying. The adhesive **1328** may be applied using any suitable technique where in one example technique the adhesive **1328** is sprayed onto the substrate with a spray gun. After application of the adhesive **1328**, the substrate is pre-cured at 80°C for about two minutes, for example.

Dielectric film **1330** and electrode **1334** materials are laminated and printed **1308** onto the substrate. The process steps **1306** and **1308** are repeated until a desired number of dielectric layers is formed. For the dielectric film **1330** lamination portion of the process step **1308**, the dielectric film **1330** is prepared on a batch frame. The first liner is removed and the dielectric film **1330** is rolled onto the stack and then the second liner is removed. A single or several patterns of electrodes **1334** may be used. Electrode **1334** patterns may be alternated on each layer. In one embodiment, the electrodes are screen printed on each layer.

Once a desired number of multiple layers of the stacked actuator have been fabricated, vias are pierced into the stack and filled **1310** with an electrically conductive material such as an elastomer loaded with conductive particles of, for example, carbon black, or silver **1334**. The actuator is then tested **1312** for voltage withstand, resistance, and capacitance. Because the process has been carried on a frame with multiple substrates, the stacked actuators may now be singulated **1314** into individual components ready for the actuator assembly **1316** process. For the actuator assembly process **1316**, a printed circuit board **1336** with ring-shaped armatures **1330** soldered thereon is prepped and placed along with two stacked actuators into a mold. Conductive elastomer **1340** is injected and cured. The actuators are then placed into a potting mold and potting elastomer **1342**, **1344** is injected and cured to provide an encapsulation layer. The actuator assembly is tested **1348** and data **1346** is collected and analyzed. At decision block **1320** it is determined if the actuator assembly passed or failed the test. If it passed the test, it is placed in inventory **1322**. Otherwise it is rejected **1348**.

Some of the individual steps in the actuator assembly process **1316** are now explained in additional detail. In the printed circuit board **1336** preparation step, for example, ring-shaped test-points (two per printed circuit board element) are soldered to the printed circuit boards **1336** that comprise the bases of the actuator assemblies. Any residual soldering flux is then removed.

Prior to inserting the prepped printed circuit board **1336** into the mold with the two stacked actuator components (actuators), any residual material is cleared from the mold ports and cavities. One the mold is loaded, it is closed, and vacuum is applied to remove any residual air from the assembly.

The conductive elastomer **1340** is then injected into the mold at, for example, 45 PSI (0.31 MPa), although other suitable pressures are contemplated to be within the scope of the present disclosure. The entire mold is then placed in an oven to cure the conductive elastomer **1340**. Once the conductive elastomer **1340** has cured, the mold is removed from the oven and the molded actuators are ejected. Any flash or burrs left by the molding process are preferably trimmed away.

The potting die is prepared by cleaning the injection ports and cavities. The actuators are then loaded into the potting dies so that the printed circuit board bases **1336** rest on an inner shoulder. This defines a void on the actuator side of the printed circuit board into which potting compound is injected. The mold is then closed.

A two-part elastomer potting compound **1342**, **1344** is mixed, degassed under vacuum, and injected into the cavity through injection ports. The injection ports are then closed and the filled mold is cured in an oven. After curing, the mold is opened, the actuators are ejected, and any molding flash trimmed away.

Next, an electrical shield may optionally be laminated over the actuators, The layer may be comprised of, for example, two insulating layers of thermoplastic urethane (TPU) sandwiching a conductive layer of metallized fabric. To facilitate assembly, a sheet of this composite shield may be vacuum-formed and trimmed to fit the actuators .

As used herein dielectric elastomer film may include, without limitation, silicone elastomers, acrylic elastomers, polyurethanes, thermoplastic elastomers, copolymers comprising polyvinylidene difluoride, pressure-sensitive adhesives, fluoroelastomers, polymers comprising silicone and acrylic moieties, and the like. The polymer matrix of the dielectric elastomer film may be a homopolymer or copolymer, cross-linked or uncross-linked, linear or branched, etc. As will be apparent to those skilled in the art, combinations of some of these materials may be used as the polymer matrix in methods of this invention. Copolymers and blends fall within the class of suitable polymers.

As used herein passive polymer materials include, without limitation, at least the following materials silicone elastomers, acrylic elastomers, polyurethanes, thermoplastic elastomers, copolymers comprising polyvinylidene difluoride, pressure-sensitive adhesives, fluoroelastomers, polymers comprising silicone and acrylic moieties, and the like.

As used herein electrode materials include, without limitation, carbon or metal filled formulations, metal which may be textured or patterned, conductive polymers, and combinations thereof.

As used herein adhesive materials include, without limitation, at least the following materials, polyurethanes, silicones, olefinic polymers and copolymers, polyesters, acrylates, methacrylates, styrenic polymers and copolymers, vinyl polymers, thermoplastic elastomers, polyamides, cyanoacrylates, and combinations of these materials.

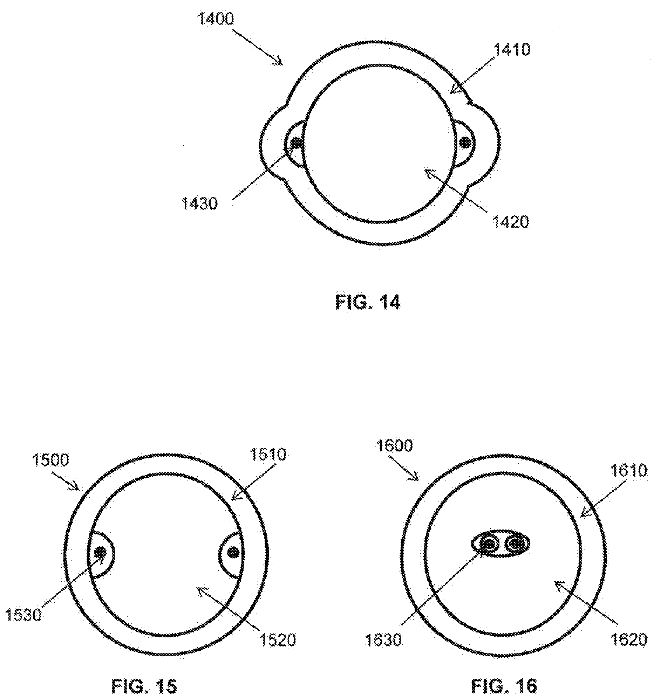

FIG. 14 illustrates the standard method **1400** of positioning electrical contacts on the outside of a stacked actuator. As can be appreciated by reference to FIG. 14, inactive area **1410** surrounds the active area **1420** with the vias **1430** placed outside of the active area. Such an arrangement consumes more space when integrated into application assemblies because the tabs extend from the active zone. The simple cut pattern requires considerable inactive wasted space. Additionally, the electrical contact at the end restricts movement.

FIG. 15 shows one embodiment of the internal contact stacked actuator of the present invention in which the vias **1530** are placed completely within the active area **1520** of the stacked actuator **1500.** The active area of the device **1520** is surrounded by the inactive area **1510**. As can be appreciated, passing the contact vias **1530** through the center of the stacked actuator **1500** is a more efficient use of space as it locates them in an area of zero motion which may result in enhanced performance for some applications. This arrangement may be used in a variety of geometries including round, square, rectangular, etc.

FIG. 16 depicts another embodiment of the internal contact stacked actuator of the present invention in which the vias **1630** are placed in the center of the footprint of the active area **1620** of the stacked actuator **1600.** The active area **1620** is surrounded by the inactive area **1610.** Additional advantages of this type of arrangement may include: higher power density of actuator; easier integration into application product; smaller ultimate size for application product, slightly higher overall performance; better isolation of electrical connections; and shorter path for charging capacitor could reduce resistance heating and speed actuation response.

As for other details of the present invention, materials and alternate related configurations may be employed as within the level of those with skill in the relevant art. The same may hold true with respect to process-based aspects of the invention in terms of additional acts as commonly or logically employed. In addition, though the invention has been described in reference to several examples, optionally incorporating various features, the invention is not to be limited to that which is described or indicated as contemplated with respect to each variation of the invention. Various changes may be made to the invention described and equivalents (whether recited herein or not included for the sake of some brevity) may be substituted without departing from the scope of the invention defined by the claims. Any number of the individual parts or subassemblies shown may be integrated in their design. Such changes or others may be undertaken or guided by the principles of design for assembly.

Also, it is contemplated that any optional feature of the inventive variations described may be set forth and claimed independently, or in combination with any one or more of the features described herein. Reference to a singular item, includes the possibility that there are plural of the same items present. More specifically, as used herein and in the appended claims, the singular forms "a," "an," "said," and "the" include plural referents unless the specifically stated otherwise. In other words, use of the articles allow for "at least one" of the subject item in the description above as well as the claims below. It is further noted that the claims may be drafted to exclude any optional element. As such, this statement is intended to serve as antecedent basis for use of such exclusive terminology as "solely," "only" and the like in connection with the recitation of claim elements, or use of a "negative" limitation. Without the use of such exclusive terminology, the term "comprising" in the claims shall allow for the inclusion of any additional element irrespective of whether a given number of elements are enumerated in the claim, or the addition of a feature could be regarded as transforming the nature of an element set forth in the claims. Stated otherwise, unless specifically defined herein, all technical and scientific terms used herein are to be given as broad a commonly understood meaning as possible while maintaining claim validity.

Various aspects of the subject matter described herein are set out in the following numbered clauses:
1. A method of fabricating a stacked electroactive transducer, the method comprising: providing a multilayer stack in a cyclic process and during each cycle, applying a first dielectric material layer to the multilayer stack; applying to the first dielectric material layer a first electrode material in at least a first pattern; applying a second dielectric material layer to the multilayer stack; and applying to the multilayer stack a second electrode material in at least a second pattern.
2. The method according to Claim 1, wherein applying the first dielectric material comprises applying to the film and at least partially curing a polymer resin.
3. The method according to Claim 1, wherein applying the first dielectric material comprises laminating a polymer film from a roll.
4. The method according to any one of Claims 1 to 3 further comprising applying an adhesive to the polymer film.
5. The method according to any one of Claims 1 to 4 further comprising applying at least one passive polymer layer as part of the stacked electroactive transducer.
6. The method according to any one of Claims 1 to 5, wherein the cyclic process comprises a continuous loop process.
7. The method according to Claim 6, wherein the continuous loop process includes a belt supported by at least two rollers to support the polymer film.
8. The method according to Claim 6, wherein the continuous loop process includes a rotating drum to support the polymer film.
9. The method according to any one of Claims 6 to 8, wherein film application and electrode application and optionally adhesive application and passive layer application occur at sites distributed around the continuous loop.
10. The method according to any one of Claims 1 to 5 further comprising: applying and advancing the first dielectric material a fixed length; applying the first electrode material to the first dielectric material; optionally, applying a first adhesive material to the first dielectric material; optionally, cutting the first dielectric material to a predetermined length; applying the second dielectric material over the first electrode and adhesive material of the first dielectric material to form a multilayer stack; optionally, curing the multilayer stack; applying the second electrode material to the multilayer stack; optionally, applying a second adhesive material to the multilayer stack; optionally, repeating the steps of applying dielectric material and applying electrode material; optionally, applying a passive polymer layer over the multilayer stack; cutting the multilayer stack to a sheet of a predetermined length; and optionally, stacking and laminating the cut multilayer stack sheets.
11. The method according to any one of Claims 1 to 10 further comprising: providing first vias to connect electrode layers with the first electrode pattern and second vias to connect the electrode layers with the second electrode pattern and filling the first and second vias with a conductive material; and optionally, singulating one or more individual devices from the multilayer stack.
12. A stacked transducer made according to the method of any one of Claims 1 to 11.
13. The stacked transducer according to Claim 12, wherein the first and second vias are positioned within the footprint of the transducer.
14. The stacked transducer according to Claim 13, wherein the first and second vias are positioned substantially at the center of the footprint of the transducer.
15. An actuator comprising a stacked transducer made according to the method of Claim 12 or 13.
16. A method of producing an actuator assembly, the method comprising: providing at least two stacked actuators; piercing at least one via through each of the at least two stacked actuators; and filling the at least one via with a conductive material.

## Claims

1. A method of fabricating a multilayer stacked electroactive transducer, the method comprising:
providing a surface to a cyclic process,
wherein each cycle of the cyclic process comprises:
applying a first dielectric material layer to the surface;
applying to the first dielectric material layer a first electrode material in at least a first pattern;
applying a second dielectric material layer to the surface; and
applying to the multilayer stack a second electrode material in at least a second pattern, **characterised in that** at least one cycle of the cyclic process further comprises applying a passive layer to the surface.

2. The method according to Claim 1, wherein applying the first dielectric material to the surface comprises applying a polymer resin to the surface and at least partially curing the polymer resin.

3. The method according to Claim 1, wherein applying the first dielectric material comprises laminating a polymer film from a roll.

4. The method according to Claim 3 further comprising applying an adhesive to the polymer film.

5. The method according to any one of Claims 1 to 4, wherein the cyclic process comprises a continuous loop process.

6. The method according to any one of Claims 3 or 4, wherein the cyclic process comprises a continuous loop process including a belt supported by at least two rollers to support the polymer film.

7. The method according to any one of Claims 3 or 4, wherein the cyclic process comprises a continuous loop process including a rotating drum to support the polymer film.

8. The method according to any one of Claims 6 or 7, wherein film application, electrode application, and passive layer application, and optionally adhesive application occur at sites distributed around the continuous loop.

9. The method according to any one of Claims 1 to 4 further comprising:
applying and advancing the first dielectric material a fixed length;
applying the first electrode material to the first dielectric material;
optionally, applying a first adhesive material to the first dielectric material;
optionally, cutting the first dielectric material to a predetermined length;
applying the second dielectric material over the first electrode and adhesive material of the first dielectric material to form a multilayer stack;
optionally, curing the multilayer stack;
applying the second electrode material to the multilayer stack;
optionally, applying a second adhesive material to the multilayer stack;
optionally, repeating the steps of applying dielectric material and applying electrode material;
applying at least one passive polymer layer over the multilayer stack;
cutting the multilayer stack to a sheet of a predetermined length; and
optionally, stacking and laminating the cut multilayer stack sheets.

10. The method according to any one of Claims 1 to 9 further comprising:
providing first vias to connect electrode layers with the first electrode pattern and second vias to connect the electrode layers with the second electrode pattern and filling the first and second vias with a conductive material; and
optionally, singulating one or more individual devices from the multilayer stack.

11. A multilayer stacked electroactive transducer made according to the method of any one of Claims 1 to 10.

12. The multilayer stacked electroactive transducer according to Claim 11, wherein first and second vias are positioned within a footprint of the transducer.

13. The multilayer stacked electroactive transducer according to Claim 12, wherein the first and second vias are positioned substantially at the center of the footprint of the transducer.

14. An actuator comprising a multilayer stacked electroactive transducer according to Claim 11 or 12.

## Patentansprüche

1. Ein Verfahren zum Herstellen eines mehrschichtigen gestapelten elektroaktiven Wandlers, wobei das Verfahren Folgendes beinhaltet:
Bereitstellen einer Oberfläche an einen Kreisprozess,
wobei jeder Kreis des Kreisprozesses Folgendes beinhaltet:
Auftragen einer ersten dielektrischen Materialschicht auf die Oberfläche;
Auftragen eines ersten Elektrodenmaterials in mindestens einem ersten Muster auf die erste dielektrische Materialschicht;
Auftragen einer zweiten dielektrischen Materialschicht auf die Oberfläche; und
Auftragen eines zweiten Elektrodenmaterials in mindestens einem zweiten Muster auf den mehrschichtigen Stapel,
**dadurch gekennzeichnet, dass** mindestens ein Kreis des Kreisprozesses ferner das Auftragen einer Passivschicht auf die Oberfläche beinhaltet.

2. Verfahren gemäß Anspruch 1, wobei das Auftragen des ersten dielektrischen Materials auf die Oberfläche das Auftragen eines Polymerharzes auf die Oberfläche und mindestens teilweise das Aushärten des Polymerharzes beinhaltet.

3. Verfahren gemäß Anspruch 1, wobei das Auftragen des ersten dielektrischen Materials das Laminieren einer Polymerfolie von einer Rolle beinhaltet.

4. Verfahren gemäß Anspruch 3, das ferner das Auftragen eines Haftmittels auf die Polymerfolie beinhaltet.

5. Verfahren gemäß einem der Ansprüche 1 bis 4, wobei der Kreisprozess einen Endlosschleifenprozess beinhaltet.

6. Verfahren gemäß einem der Ansprüche 3 oder 4, wobei der Kreisprozess einen Endlosschleifenprozess beinhaltet, der ein Band, das durch mindestens zwei Rollen gestützt wird, um die Polymerfolie zu stützen, umfasst.

7. Verfahren gemäß einem der Ansprüche 3 oder 4, wobei der Kreisprozess einen Endlosschleifenprozess beinhaltet, der eine Drehwalze, um die Polymerfolie zu stützen, umfasst.

8. Verfahren gemäß einem der Ansprüche 6 oder 7, wobei die Folienauftragung, Elektrodenauftragung und Passivschichtauftragung und optional Haftmittelauftragung an Stellen stattfinden, die um die Endlosschleife verteilt sind.

9. Verfahren gemäß einem der Ansprüche 1 bis 4, das ferner Folgendes beinhaltet:
Auftragen und Vorwärtsbewegen des ersten dielektrischen Materials um eine fixierte Länge;
Auftragen des ersten Elektrodenmaterials auf das erste dielektrische Material;
optional Auftragen eines ersten Haftmaterials auf das erste dielektrische Material;
optional Schneiden des ersten dielektrischen Materials auf eine vorbestimmte Länge;
Auftragen des zweiten dielektrischen Materials über das erste Elektroden- und Haftmaterial des ersten dielektrischen Materials, um einen mehrschichtigen Stapel zu bilden;
optional Aushärten des mehrschichtigen Stapels;
Auftragen des zweiten Elektrodenmaterials auf den mehrschichtigen Stapel;
optional Auftragen eines zweiten Haftmaterials auf den mehrschichtigen Stapel;
optional Wiederholen der Schritte des Auftragens von dielektrischem Material und des Auftragens von Elektrodenmaterial;
Auftragen mindestens einer Passivpolymerschicht über den mehrschichtigen Stapel;
Schneiden des mehrschichtigen Stapels in ein Sheet einer vorbestimmten Länge; und
optional Stapeln und Laminieren der geschnittenen mehrschichtigen Stapelsheets.

10. Verfahren gemäß einem der Ansprüche 1 bis 9, das ferner Folgendes beinhaltet:
Bereitstellen erster Durchkontaktierungen, um Elektrodenschichten mit dem ersten Elektrodenmuster zu verbinden, und zweiter Durchkontaktierungen, um die Elektrodenschichten mit dem zweiten Elektrodenmuster zu verbinden, und Füllen der ersten und zweiten Durchkontaktierungen mit einem leitfähigen Material; und
optional Singulieren einer oder mehrerer individueller Vorrichtungen aus dem mehrschichtigen Stapel.

11. Ein mehrschichtiger gestapelter elektroaktiver Wandler, gefertigt gemäß dem Verfahren gemäß einem der Ansprüche 1 bis 10.

12. Mehrschichtiger gestapelter elektroaktiver Wandler gemäß Anspruch 11, wobei die ersten und zweiten Durchkontaktierungen innerhalb einer Basisfläche des Wandlers positioniert sind.

13. Mehrschichtiger gestapelter elektroaktiver Wandler gemäß Anspruch 12, wobei die ersten und zweiten Durchkontaktierungen im Wesentlichen in der Mitte der Basisfläche des Wandlers positioniert sind.

14. Ein Aktor, der einen mehrschichtigen gestapelten elektroaktiven Wandler gemäß Anspruch 11 oder 12 beinhaltet.

## Revendications

1. Un procédé de fabrication d'un transducteur électroactif empilé multicouche, le procédé comprenant :
la fourniture d'une surface à un processus cyclique,
dans lequel chaque cycle du processus cyclique comprend :
l'application d'une première couche de matériau diélectrique sur la surface ;
l'application sur la première couche de matériau diélectrique d'un premier matériau d'électrode selon au moins un premier motif ;
l'application d'une deuxième couche de matériau diélectrique sur la surface ; et
l'application sur l'empilement multicouche d'un deuxième matériau d'électrode selon au moins un deuxième motif,
**caractérisé en ce qu'**au moins un cycle du processus cyclique comprend en sus l'application d'une couche passive sur la surface.

2. Le procédé selon la revendication 1, dans lequel l'application du premier matériau diélectrique sur la surface comprend l'application d'une résine de polymère sur la surface et le durcissement au moins partiel de la résine de polymère.

3. Le procédé selon la revendication 1, dans lequel l'application du premier matériau diélectrique comprend la stratification d'un film de polymère à partir d'un rouleau.

4. Le procédé selon la revendication 3 comprenant en sus l'application d'un adhésif sur le film de polymère.

5. Le procédé selon n'importe laquelle des revendications 1 à 4, dans lequel le processus cyclique comprend un processus à boucle continue.

6. Le procédé selon n'importe laquelle des revendications 3 ou 4, dans lequel le processus cyclique comprend un processus à boucle continue incluant une courroie soutenue par au moins deux galets afin de soutenir le film de polymère.

7. Le procédé selon n'importe laquelle des revendications 3 ou 4, dans lequel le processus cyclique comprend un processus à boucle continue incluant un tambour rotatif afin de soutenir le film de polymère.

8. Le procédé selon n'importe laquelle des revendications 6 ou 7, dans lequel l'application de film, l'application d'électrode, et l'application de couche passive, et facultativement l'application d'adhésif se produisent au niveau de sites répartis autour de la boucle continue.

9. Le procédé selon n'importe laquelle des revendications 1 à 4 comprenant en sus :
l'application et le déplacement vers l'avant du premier matériau diélectrique sur une longueur fixe ;
l'application du premier matériau d'électrode sur le premier matériau diélectrique ;
facultativement, l'application d'un premier matériau adhésif sur le premier matériau diélectrique ;
facultativement, la coupe du premier matériau diélectrique à une longueur prédéterminée ;
l'application du deuxième matériau diélectrique par-dessus le premier matériau d'électrode et le premier matériau adhésif du premier matériau diélectrique afin de former un empilement multicouche ;
facultativement, le durcissement de l'empilement multicouche ;
l'application du deuxième matériau d'électrode sur l'empilement multicouche ;
facultativement, l'application d'un deuxième matériau adhésif sur l'empilement multicouche ;
facultativement, la répétition des étapes d'application de matériau diélectrique et
d'application de matériau d'électrode ;
l'application d'au moins une couche de polymère passive par-dessus l'empilement multicouche ;
la coupe de l'empilement multicouche en une feuille d'une longueur prédéterminée ; et
facultativement, l'empilement et la stratification des feuilles d'empilement multicouche coupées.

10. Le procédé selon n'importe laquelle des revendications 1 à 9 comprenant en sus :
la fourniture de premiers trous d'interconnexion afin de raccorder des couches d'électrode avec le premier motif d'électrode et de deuxièmes trous d'interconnexion afin de raccorder les couches d'électrode avec le deuxième motif d'électrode et le remplissage des premiers et deuxièmes trous d'interconnexion avec un matériau conducteur ; et
facultativement, la séparation d'un ou de plusieurs dispositifs individuels de l'empilement multicouche.

11. Un transducteur électroactif empilé multicouche réalisé selon le procédé de n'importe laquelle des revendications 1 à 10.

12. Le transducteur électroactif empilé multicouche selon la revendication 11, dans lequel des premiers et deuxièmes trous d'interconnexion sont positionnés à l'intérieur d'un encombrement du transducteur.

13. Le transducteur électroactif empilé multicouche selon la revendication 12, dans lequel les premiers et deuxièmes trous d'interconnexion sont positionnés substantiellement au centre de l'encombrement du transducteur.

14. Un actionneur comprenant un transducteur électroactif empilé multicouche selon la revendication 11 ou la revendication 12.
